# EUROPÄISCHE PATENTSCHRIFT

(11) **EP 0 411 595 B1**
(45) Veröffentlichungstag und Bekanntmachung des Hinweises auf die Patenterteilung: **27.11.1996**
(21) Anmeldenummer: 90114730.6
(22) Anmeldetag: 31.07.1990
(51) Int. Cl.: H01L 21/58, H01L 21/14, H01L 23/492

(54) **Verfahren zum Verbinden von Halbleiterchips mit einem Wafer**
Process for bonding semiconductor chips to a wafer
Procédé pour lier des puces semi-conductrices sur une plaquette

(30) Priorität: 31.07.1989 DE 3925341
(43) Veröffentlichungstag der Anmeldung: 06.02.1991
(73) Patentinhaber: SIEMENS AKTIENGESELLSCHAFT, 80333 München (DE)
(72) Erfinder: Althaus, Hans-Ludwig, Dr.Dipl.-Phys., D-8417 Lappersdorf (DE); Bogner, Georg, Dipl.-Phys., D-8430 Neumarkt (DE); Hufgard, Erich, Dipl.-Phys., D-8400 Regensburg (DE)

(56) Entgegenhaltungen:
- US-A- 4 506 139
- PATENT ABSTRACTS OF JAPAN vol. 3, no. 132 (E-149)6. November 1979 & JP-A- 54 110 786
- PATENT ABSTRACTS OF JAPAN vol. 10, no. 272 (E-437)(2328) 16. September 1986 & JP-A-61 93 634
- NTIS TECH NOTES, April 1990, SPRINGFIELD, VA US Seite 325; J.T. RICE: 'Removing bonded integrated circuits from boards'

## Beschreibung

Die Erfindung betrifft ein Verfahren zum Verbinden von Halbleiterchips mit einem Wafer, der lokal erhitzbare Bereiche aufweist, unter Verwendung eines thermisch reagierenden Bindemittels.

Ein Verfahren zum Verbinden von Hybrid-Chips mit einem Hybrid-Substrat ist beispielsweise aus der US-Patentschrift 4,506,139 bekannt. Hierbei sind Heizstrukturen auf den Hybrid-Chips aufgebracht.

Das Auflöten oder Kleben von Halbleiterbauelementen auf einen Zwischenträger wird bekanntlich durch Aufheizen des Zwischenträgers mittels einer externen Heizquelle, beispielsweise eines Heizbandes oder -tisches vorgenommen. Derartige Heizsysteme sind aufgrund ihrer Masse relativ träge oder im Falle der Verwendung eines Heizbandes nicht ausreichend formstabil, weil das Heizband beim Aufheizen zur Welligkeit und damit zu Unebenheiten in der Auflagefläche neigt.

Der Erfindung liegt die Aufgabe zugrunde, diese Nachteile zu vermeiden und ein Verfanren zum Verbinden von Halbleiterchips mit einem Wafer anzugeben, das durch Ausnutzen eines ohmschen Widerstandes, Scnottky-Kontaktes oder pn-Überganges von Halbleitersubstraten ein gezieltes, reaktionsschnelles, steuerbares und mit geringer Verlustleistung behaftetes Verbinden ohne Flußmittel ermöglicht.

Diese Aufgabe wird bei einem Verfahren der eingangs genannten Art mit den Kennzeichen des Anspruches 1 gelöst.

Als Halbleitermaterial für den Wafer wird dabei vorzugsweise Silizium und als Bindemittel ein Lot, ein Kleber oder ein thermisch reagierender Kunststoff verwendet.

Das Aufbringen des Bindemittels auf die Waferoberfläche bzw. auf bestimmte Teile des Wafers, an denen die Halbleiterbauelemente bzw. Halbleiterchips befestigt werden sollen, wird zweckmäßig durch Auftragen, Aufdampfen oder als Preßform vorgenommen. Vorzugsweise wird man die Halbleiterchips, sofern nicht andere Gesichtspunkte überwiegen, an Stellen auf dem Wafer anordnen, die in unmittelbarer Nähe der lokal erhitzbaren Bereiche liegen.

Bei dem erfindungsgemäßen Verfahren wird ein pn-Übergang oder das ohmsche Verhalten eines entsprechend ausgebildeten Halbleiters zur Wärmebildung ausgenutzt. Falls die Halbleiterstruktur als Transistor ausgebildet ist, kann mit besonderem Vorteil zusätzlich die Temperaturabhängigkeit des Basisstroms zur Regelung verwendet werden.

Das erfindungsgemäße Verfahren mit einem Halbleitersubstrat als Wärmequelle bietet gegenüber herkömmlichen Heizsystemen aus Metall, beispielsweise in Form von Heizbändern oder -tischen, insbesondere folgende Vorteile:
a) höherer elektrischer Widerstand, dadurch Verringerung des Leitungsquerschnittes der elektrischen Zuleitungen;
b) geringere Masse, dadurch geringere Verlustleistung und höhere Dynamik;
c) durch unterschiedliche Dotierung in weitem Bereich einstellbarer elektrischer Widerstand des Halbleitermaterials, dadurch Verbesserung der Ansteuermöglichkeit.

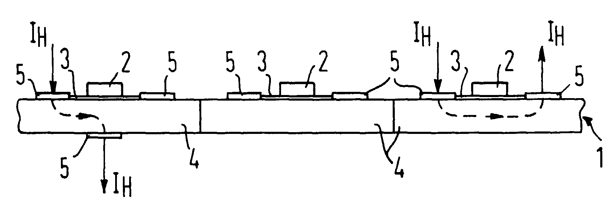

Anhand eines in der Figur der Zeichnung dargestellten Ausführungsbeispiels wird die Erfindung näher erläutert.

Die Figur zeigt rein schematisch teilweise im Schnitt ein Si-Wafer 1 mit eindiffundiertem pn-Übergang in Schachbrettstruktur, dessen Felder 4 gegeneinander elektrisch isoliert sind. Das Bindemittel 3, vorzugsweise ein Lot, Kleber oder thermisch reagierender Kunststoff, kann aufgetragen, aufgedampft oder in geeigneter Preßform angeboten werden. Das betreffende, mit einem Halbleiterchip 2 versehene Si-Feld 4 wird elektrisch angeschlossen. Der elektrische Anschluß erfolgt beispielsweise über Kontakte 5, die entweder nur auf einer Seite des Wafers 1 (vgl. rechten Waferteil) oder auf beiden Seiten des Wafers 1 (vgl. linken Waferteil) angeordnet sein können. Als elektrische Anschlußkontakte 5 können auch Kontaktfedern oder Kontaktstifte verwendet werden. Der mit Pfeilen angedeutete Heizstrom I_{H} in Durchlaßrichtung oder in Sperrichtung führt zu einer lokalen Temperaturerhöhung im Wafer 1, die die gewünschte Reaktion, nämlich Löten oder Kleber aushärten, bewirkt.

Die Vorteile des erfindungsgemäßen Verfahrens bestehen auch darin, daß sehr kleine Massen erwärmt werden, indem man auf kompletten Wafern 1 nur bestimmte Zonen aufheizt. Zudem sind die Verhältnisse sehr gut reproduzierbar, so daß man durch die Wahl der Strompulsform den Temperaturverlauf vorgeben kann.

Das erfindungsgemäße Verfahren läßt sich beispielsweise mit besonderem Vorteil zum Auflöten von Halbleiter-Lasern auf Silizium-Zwischenträgern im Scheibenverband (Wafer) verwenden und ermöglicht zudem eine kostengünstige Alterung.

## Patentansprüche

1. Verfahren zum Verbinden von Halbleiterchips (2) mit einem Wafer (1), bei dem
- der Wafer (1) lokal erhitzbare Bereiche (4) aufweist,
- ein thermisch reagierendes Bindemittel (3) zumindest auf die lokal erhitzbaren Bereiche (4) aufgebracht wird,
- die Halbleiterchips (2) auf dem Bindemittel angeordnet werden und
- das Bindemittel (3) mittels Stromdurchgang durch die lokal erhitzbaren Bereiche (4) erhitzt wird,
**dadurch gekennzeichnet**, daß
- die lokal erhitzbaren Bereiche (4) durch Ausnutzen eines ohmschen Widerstands, Schottky-Kontaktes oder pn-Überganges, in einem Halbleiterwafer (1) erzeugt werden.

2. Verfahren nach Anspruch 1, **dadurch gekennzeichnet**, daß als Halbleitermaterial für den Wafer (1) Silizium verwendet wird.

3. Verfahren nach Anspruch 1 oder 2, **dadurch gekennzeichnet**, daß als Wafer (1) eine als Transistor ausgebildete Halbleiterstruktur verwendet wird, und daß zum Regeln des Aufheizvorganges zusätzlich die Temperaturabhängigkeit des Basisstromes dieser Transistorstruktur ausgenutzt wird.

4. Verfahren nach einem der Ansprüche 1 bis 3, **dadurch gekennzeichnet**, daß als Bindemittel (3) ein Lot, ein Kleber oder ein thermisch reagierender Kunststoff verwendet wird.

5. Verfahren nach einem der Ansprüche 1 bis 4, **dadurch gekennzeichnet**, daß das Aufbringen des Bindemittels (3) durch Auftragen, Aufdampfen oder als Preßform vorgenommen wird.

6. Verfahren nach einem der Ansprüche 1 bis 5, **dadurch gekennzeichnet**, daß ein Si-Wafer (1) mit eindiffundiertem pn-Übergang in Schachbrettstruktur, dessen Felder als lokal erhitzbare Bereiche gegeneinander isoliert sind, verwendet wird, daß das Bindemittel (3) aufgetragen wird, daß das mit einem Halbleiterchip (2) versehene Si-Feld elektrisch angeschlossen wird, und daß ein elektrischer Strom in Durchlaß- oder Sperrichtung zugeführt wird, so daß die zum Verbinden benötigte lokale Temperaturerhöhung erzeugt wird.

## Claims

1. Process for joining semiconductor chips (2) to a wafer (1), in which
- the wafer (1) has locally heatable regions (4),
- a binder (3) which reacts to heat is applied at least to the locally heatable regions (4),
- the semiconductor chips (2) are arranged on the binder, and
- the binder (3) is heated by passing current through the locally heatable regions (4),
characterized in that
- the locally heatable regions (4) are produced in a semiconductor wafer (1) by utilizing a non-reactive resistor, Schottky contact or pn junction.

2. Process according to Claim 1, characterized in that silicon is used as the semiconductor material for the wafer (1).

3. Process according to Claim 1 or 2, characterized in that a semiconductor structure designed as a transistor is used as the wafer (1), and in that the temperature dependence of the base current of this transistor structure is additionally utilized for regulating the heating process.

4. Process according to one of Claims 1 to 3, characterized in that a solder, an adhesive or a plastic which reacts to heat is used as the binder (3).

5. Process according to one of Claims 1 to 4, characterized in that the binder (3) is applied by coating, vapour-deposition or using a mould.

6. Process according to one of Claims 1 to 5, characterized in that use is made of an Si wafer (1) having an indiffused pn junction in a chessboard structure, the fields of which are insulated from one another as locally heatable regions, in that the binder (3) is applied by coating, in that the Si field provided with a semiconductor chip (2) is electrically connected, and in that an electric current is supplied in the forward or reverse direction, thereby producing the local temperature increase required for the joining process.

## Revendications

1. Procédé pour relier des puces (2) à semiconducteurs à une galette (1), dans lequel
- la galette (1) comporte des zones (4) pouvant être chauffées de manière localisée,
- un liant (3) réagissant thermiquement est déposé au moins sur les zones (4) pouvant être chauffées de manière localisée,
- le liant (3) peut être chauffé au moyen d'un passage de courant dans les zones (4) pouvant être chauffées de manière localisée,
caractérisé en ce que
- les zones (4) pouvant être chauffées de manière localisée sont produites en tirant parti d'une résistance ohmique, d'un contact Schottky ou d'une jonction pn.

2. Procédé suivant la revendication 1, caractérisé en ce que l'on utilise pour la galette (1) du silicium comme matériau semiconducteur.

3. Procédé suivant la revendication 1 ou 2, caractérisé en ce que l'on utilise comme galette (1) une structure de semiconducteur réalisée sous forme de transistor, et en ce que, pour réguler l'opération de chauffage, on tire parti en plus de la variation du courant de base de cette structure de transistor en fonction de la température.

4. Procédé suivant l'une des revendications 1 à 3, caractérisé en ce que l'on utilise comme liant (3) un matériau de brasage tendre, une colle ou une matière plastique réagissant thermiquement.

5. Procédé suivant l'une des revendications 1 à 4, caractérisé en ce que l'on procède au dépôt du liant (3) par dépôt, par dépôt en phase vapeur ou par moulage.

6. Procédé suivant l'une des revendications 1 à 5, caractérisé en ce que l'on utilise une galette (1) en Si ayant une jonction pn diffusée de structure en échiquier, dont les zones servant de zones pouvant être chauffées de manière localisée sont isolées les unes des autres, en ce que la zone de Si munie d'une puce (2) à semiconducteurs est raccordée électriquement, et en ce qu'un courant électrique est envoyé dans le sens de conduction ou en sens opposé au sens de conduction, si bien que l'élévation localisée de température nécessaire à la liaison est produite.
